Europäisches Patentamt

European Patent Office

Office européen des brevets

(19)

(11) Veröffentlichungsnummer : **0 161 447**
**B1**

(12) # EUROPÄISCHE PATENTSCHRIFT

(45) Veröffentlichungstag der Patentschrift :
13.12.89

(51) Int. Cl.⁴ : **G 01 R 21/133**, G 01 R 21/14

(21) Anmeldenummer : 85103846.3

(22) Anmeldetag : 29.03.85

(54) Elektronischer Energieverbrauchszähler.

(30) Priorität : 17.04.84 DE 3414520

(43) Veröffentlichungstag der Anmeldung :
21.11.85 Patentblatt 85/47

(45) Bekanntmachung des Hinweises auf die Patenterteilung : 13.12.89 Patentblatt 89/50

(84) Benannte Vertragsstaaten :
AT CH DE FR GB LI SE

(56) Entgegenhaltungen :
EP—A— 0 008 630
EP—A— 0 057 978
FR—A— 2 357 907
GB—A— 2 082 785
IEEE TRANS. ON INDUSTRIAL ELECTR. & CONTROL INSTR., Band IECI-28, Nr. 3, August 1981, Seiten 180-184, IEEE, New York, US; J.J. HILL et al.: "Design of a microprocessor-based digital Wattmeter"
WESCON CONFERENCE RECORD, Band 25, September 1981, Seiten 1-7(7/2), El Segundo, CA, US; R. TALAMBIRAS: "Sampling network analyzer for periodic functions"

(73) Patentinhaber : Fr. Sauter AG Fabrik elektr. Apparate
Im Surinam 55
CH-4016 Basel (CH)

(72) Erfinder : Brückner, Markus
St. Alban Ring 202
CH-4052 Basel (CH)
Erfinder : Mösch, Ralph
Im Kirschgarten 37
CH-4102 Binningen (CH)

(74) Vertreter : Betten, Jürgen, Dipl.-Ing. et al
Patentanwälte Betten & Resch Reichenbachstrasse 19
D-8000 München 5 (DE)

**Beschreibung**

Die Erfindung betrifft einen elektronischen Energieverbrauchszähler nach dem Oberbegriff des Anspruchs 1.

Zähler für die Verrechnung elektrischer Energie sind in Haushalt und Industrie bisher vorwiegend in elektromechanischer Ausführung mit Ferrarisscheibe als Motor ausgeführt worden. Elektronische Zähler werden demgegenüber bisher nur als Präzisionszähler verwendet, die nach dem Pulsfrequenz- (Mark and Space) arbeiten. Außerdem sind analoge Multiplikationsverfahren bekannt, welche an der Kennlinie der Basis-Emitter-Strecke von Transistoren arbeiten. Hierzu wird verwiesen auf den Multiplizierer mit logarithmierenden Funktionsgeneratoren in Tietze/Schenk, 2. Auflage, Seite 288. Dieses letztgenannte Verfahren hat jedoch den Nachteil, daß es bezüglich Langzeit- und Temperaturstabilität sehr schwer auf die erforderliche Genauigkeit in einem größeren Meßbereich zu bringen ist.

Die bekannten Verfahren haben darüber hinaus den Nachteil, daß sie schaltungsmäßig sehr aufwendig und damit kostspielig sind.

Aus IEEE TRANS. ON INDUSTRIAL ELECTR. & CONTROL INSTR., Band IECI-28, Nr. 3, August 1981, Seiten 180-184, IEEE, New York, US; J.J. Hill et al.: « Design of a microprocessor-based digital Wattmeter » ist ein elektronischer Energieverbrauchszähler nach dem Oberbegriff des Anspruchs 1 bekannt, wobei allerdings anstelle des Schalters ein Analog-Multiplexer verwendet wird. Mit einem derartigen Zähler kann jedoch die geforderte Meßgenauigkeit über einen großen dynamischen Strombereich nur mit einem aufwendigen A/D-Wandler erreicht werden.

Demgegenüber besteht die Aufgabe der Erfindung darin, einen elektronischen Energieverbrauchszähler der obenbeschriebenen Art zu schaffen, mit dem die Verbrauchsenergie mit der erforderlichen Genauigkeit und in einem größeren Meßbereich gemessen und der Schaltungsaufwand trotzdem so gering gehalten werden kann, daß der elektronische Energieverbrauchszähler sich für die Massenfabrikation eignet und damit auch als Haushaltszähler verwendet werden kann.

Diese Aufgabe wird dadurch gelöst, daß der Nebenwiderstand und der Meßwiderstand thermisch eng miteinander gekoppelt sind, so daß sich der Meßwiderstand bei Temperaturänderungen prozentual gleich verändert wie der Nebenwiderstand und so ein temperaturkompensiertes Spannungssignal $V_i$ am Ausgang des Operationsverstärkers geliefert wird.

Dadurch, daß der Strommeßkreis ein temperaturkompensiertes Spannungssignal $V_i$ liefert, ist es nicht erforderlich, temperaturabhängige Kompensationsschaltungen oder teure temperaturstabile Shunt-Materialien einzusetzen.

Dadurch, daß sowohl der Spannungs- als auch der Strommeßkreis eisenlos sind, ist der erfindungsgemäße elektronische Energieverbrauchszähler gegenüber Gleichstromanteilen im Spannungs- und Strompfad unempfindlich, im Gegensatz zu den bekannten Ferrarizählern und Zählern mit Stromwandlern. Außerdem gestattet das eisenlos und daher ohne Sättigungserscheinungen arbeitende, temperaturkompensierte Strommeßverfahren mit einem Shunt auch eine Messung hoher Ströme, z. B. bis 90 A in einem Einphasenzähler, und dies einfach und kostengünstig, ohne daß Phasenfehler auftreten.

Damit wird mit geringem Schaltungsaufwand ein Zähler geschaffen, der sich für die Massenfertigung und damit auch als Haushaltszähler eignet.

Weitere vorteilhafte Ausführungsformen der Erfindung sind in den Ansprüchen 2 bis 6 beschrieben.

Ausführungsbeispiele der Erfindung werden anhand der Zeichnungen näher beschrieben. Es zeigen:

Fig. 1 ein Blockschaltbild eines erfindungsgemäßen elektronischen Energieverbrauchszählers;

Fig. 2 eine vergrößerte perspektivische Darstellung der Anschlußklemmen sowie der Eingangsschaltung des erfindungsgemäßen Zählers und

Fig. 3 Ein Kurvenschaubild zur Verdeutlichung des Abtastprinzips anhand der Abtastwerte von Strom, Spannung und momentaner Leistung.

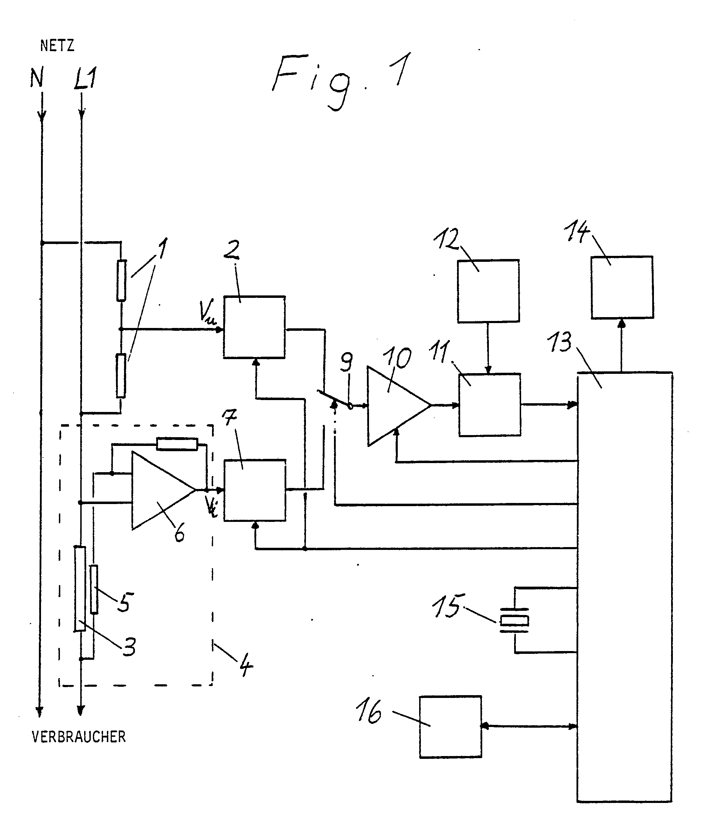

Bei dem in Fig. 1 dargestellten Blockschaltbild ist ein Einphasenzähler auf der Phase L1 eines Drehstromnetzes mit Nulleiter N angeschlossen dargestellt. Zwischen Nulleiter N und Phase L1 ist ein Spannungsteiler 1 geschaltet, an dem ein zur Verbraucherspannung proportionale Spannungssignal $V_u$ abgenommen und einer ersten Abtast- und Halteschaltung (Sample-and-Hold-Schaltung; S/H-Schaltung) 2 zugeführt wird.

Zwischen Phaseneingang und -ausgang ist ein Nebenwiderstand oder Shunt 3 geschaltet, der damit parallel zu einem Strommeßkreis 4 liegt, in dem ein zum Verbraucherstrom proportionales Spannungssignal $V_i$ ermittelt wird. Der Strommeßkreis 4 weist einen Meßwiderstand 5 sowie einen Operationsverstärker 6 auf, dessen erster Eingang mit dem Phaseneingang und dessen zweiter Eingang mit dem Meßwiderstand 5 verbunden ist. Das am Ausgang des Operationsverstärkers 6 anliegende, zum Verbraucherstrom proportionale Spannungssignal $V_i$ wird einer zweiten Abtast- und Halteschaltung (S/H-Schaltung) 7 zugeführt.

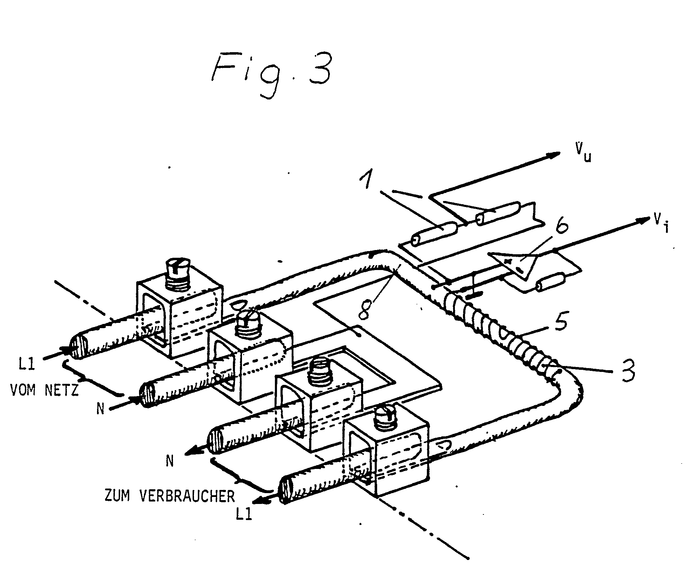

Der Shunt 3 und der Meßwiderstand 5 im Strompfad sind aus gleichem Material, z. B. Kupfer, und thermisch dadurch eng miteinander gekoppelt, daß der Meßwiderstand 5 um den Shunt 3 herumgewickelt ist, wie es am besten aus Fig. 3 zu ersehen ist. Vorzugsweise ist dabei der Shunt 3 von einem Schrumpfschlauch umgeben, der den bifilar aufgewickelten Meßwiderstand 5 auf dem Shunt 3 fixiert.

EP 0 161 447 B1

Diese Anordnung hat den Vorteil, daß sich der Meßwiderstand 5 bei Temperaturänderungen prozentual gleich verändert wie der Shunt 3, so daß der Strommeßkreis 4 ein temperaturkompensiertes Spannungssignal $V_i$ liefert, ohne daß aufwendige Konstruktionen oder teurere temperaturstabile Shuntmaterialien eingesetzt werden müssen. Vorzugsweise dient dabei als Shunt 3 der Verbindungssteg 8 zwischen Phaseneingang und -ausgang des Klemmblocks des Zählers.

Der Ausgang der beiden S/H-Schaltungen 2 und 7 ist über einen Schalter 9 abwechselnd mit einem programmierbaren Verstärker 10 und einem nachgeschalteten Analog-Digital-Wandler (A/D-Wandler) 11 verbindbar, dessen Bezugsspannung von einer Bezugsspannungsquelle 12 geliefert wird.

Der A/D-Wandler 11 ist mit einem Mikroprozessor 13 verbunden, der verschiedene Funktionsschaltungen beinhaltet und mit einer Anzeige 14 verbunden ist. Mit dem Bezugszeichen 15 ist eine Zeitreferenz und mit 16 ein netzausfallsicherer EAROM gekennzeichnet, d. h. ein elektrisch programmier-, lösch- und wiederprogrammierbarer Festwertspeicher. Außerdem ist der Mikroprozessor noch mit den S/H-Schaltungen 2 und 7 sowie mit dem programmierten Verstärker 10 verbunden.

Die im Blockschaltbild in Fig. 1 dargestellte Schaltung arbeitet wie folgt.

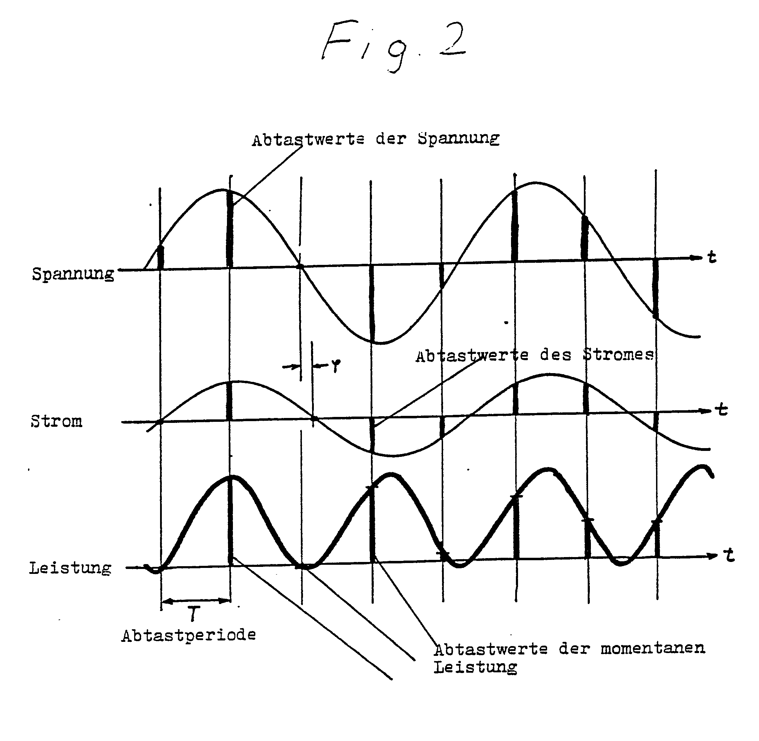

Das mittels Spannungsteiler 1 ermittelte, zur Verbraucherspannung proportionale Spannungssignal $V_u$ und das mittels Strommeßkreis 4 ermittelte, zum Verbraucherstrom proportionale Spannungssignal $V_i$ werden in den S/H-Schaltungen 2 und 7 zwischengespeichert. Mittels des Schalters 9 werden die an dem Ausgang der S/H-Schaltungen 2 und 7 anliegenden Werte mit einer vorbestimmten Abtastfrequenz abgetastet. Das Abtastprinzip ergibt sich aus Fig. 2, die den Kurvenverlauf und die Abtastwerte von Spannung, Strom und Leistung zeigt. Danach wird die Abtastfrequenz so gewählt, daß mindestens zwei Abtastwerte pro Periode im Leistungsbereich, d. h. wenigstens vier Abtastwerte pro Netzperiode im Spannungs- und Strombereich verarbeitet werden. Die Abtastfrequenz wird ferner so gewählt, daß sie bei den möglichen Abweichungen der Netzfrequenz immer asynchron zum Netz bleibt, damit periodische Signale in der Grundfrequenz des Netzes mit beliebigen Kurvenformen in allen Phasenlagen genau abgetastet werden, was insbesondere für die Messung des Stromes wichtig ist.

Die von den S/H-Schaltungen 2 und 7 gelieferten Abtastwerte werden über den programmierbaren Verstärker 10 von dem A/D-Wandler 11 nacheinander digitalisiert und unabhängig voneinander im Mikroprozessor 13 abgespeichert. Dadurch ist es möglich, daß je nach Wahl der Software vom Mikroprozessor 13 die Wirk- und/oder Blindleistung ausgewertet und angezeigt werden kann.

Die im Mikroprozessor 13 gespeicherten digitalen Spannungswerte $V_{ud}$ und $V_{id}$ werden im Mikroprozessor 13 in einer Multiplikationsschaltung multipliziert und dann in einer Integrationsschaltung integriert, so daß damit die verbrauchte momentane Leistung erhalten wird und diese beispielsweise in der Anzeige 14 angezeigt werden kann.

Dadurch daß die Spannungswerte $V_{ud}$ und $V_{id}$ unabhängig voneinander im Mikroprozessor 13 gespeichert werden, ist es auch möglich, etwaige Strom- oder Spannungsoffsetfehler dadurch im Mikroprozessor 13 zu beseitigen, daß laufend über Sekunden bis Minuten der Mittelwert der digitalen Spannungsabtastwerte $V_{ud}$ und $V_{id}$ gebildet und sich daraus ergebende Nullpunktsverschiebungen jedem Abtastwert im korrigierenden Sinne hinzuaddiert oder subtrahiert werden, bevor die Abtastwerte der Multiplikationsschaltung im Mikroprozessor 13 zugeführt werden.

Eine Eichung des Zählers wird dadurch vorgenommen, daß vorab eine Eichmessung mit einem Präzisionszähler durchgeführt, der Eichfaktor einmalig für jedes Gerät individuell ermittelt und in dem EAROM 16 der Eichfaktor abgespeichert wird, mit dem die Meßwerte des Zählers dann im Mikroprozessor multipliziert werden. Dadurch entfallen sämtliche analogen Trimmoperationen in der Meßschaltung, wie sie bei den bekannten Zählern erforderlich sind, was für die Zuverlässigkeit und rationelle Fertigung von hoher Wichtigkeit ist.

Da die Eichung des Zählers durch eine Korrekturoperation im Mikroprozessor erfolgt, sind die Anforderungen an die analogen Schaltungsteile (Linearität des A/D-Wandlers und des programmierbaren Verstärkers, der Spannungs- und Zeitreferenz) nur noch bezüglich relativer Genauigkeit, Langzeit- und Temperaturstabilität hoch, bezüglich absoluter Genauigkeit können jedoch Toleranzen akzeptiert werden, welche mit Halbleiterschaltungen als On-Chip-Lösungen erreicht werden können. Die Möglichkeit der Halbleiterintegration des Meßkreises eröffnet damit den Weg zur rationellen und zukunftsgerichteten Fertigung voll elektronischer Zähler.

Vorzugsweise erfolgt die Analog-Digital-Wandlung des zum Verbrauchstrom proportionalen Spannungswerts $V_i$ in zwei Schritten. Im ersten Schritt wird der programmierbare Verstärker 10 auf die kleinste Verstärkung (Verstärkungsfaktor 1) eingestellt und mit dem A/D-Wandler wird die Größenordnung der Amplitude des Spannungswerts grob festgestellt. Im zweiten Schritt wird aufgrund der ersten Messung im programmierbaren Verstärker einer der Verstärkungsfaktoren 1, 2, 4, 8, 16, 32, 64, 128 angewählt und zwar so, daß der nachfolgende A/D-Wandler möglichst voll ausgesteuert wird. Dieses Verfahren hat den Vorteil, daß eine gleichbleibende prozentuale Genauigkeit der Meßwerte über den gesamten Amplitudenbereich von über 1 : 100 des A/D-Wandlers gewährleistet ist. Damit ist es möglich, sowohl einen geringen als auch einen großen Verbrauch genau anzuzeigen. Mit der Analog-Digital-Wandlung des zum Verbraucherstrom proportionalen Spannungswerts $V_i$ in zwei Schritten wird damit eine gleichbleibende relative Genauigkeit über einen großen Meßbereich erreicht, was den an einen Elektrizitätszähler gestellten Anforderungen entspricht.

Bei einer weiteren Ausgestaltung der Erfindung wird der Wert der jeweils ermittelten verbrauchten

3

Energie ebenfalls im EAROM gespeichert. Dies erlaubt es, die Ablesung des Zählerstands und evtl. weiterer Angaben wie Überschreitung der tariflich vereinbarten maximal zulässigen momentanen Leistung usw. nicht nur über die Anzeige vor Ort vorzunehmen, sondern auch über zwei Drahtleitungen, Telefonmodems oder Zweiweg-Rundsteuersysteme an einen entfernten Ort oder an das Elektrizätswerk direkt zurückzumelden. Dadurch können viele Probleme im Zusammenhang mit der Zählerablesung wesentlich verbessert werden. Eine Abwesenheit der Bewohner bei der Ablesung stört nicht mehr. Eine genaue und fehlerfreie, da automatische Zählerablesung ist ebenso möglich wie eine Signalisierung von unerlaubten Manipulationen am Zählgerät.

Durch die unabhängige Messung von Strom und Spannung sowie der unabhängigen Speicherung der dazu proportionalen Spannungswerte kann auch die Überschreitung von Spitzenwerten in Strom, Blind- oder Wirkleistung nach Bedarf signalisiert oder tariflich entsprechend gezählt werden.

Bei einer weiteren Ausgestaltung der Erfindung sind pro Phase jeweils zwei Abtast- und Halteschaltungen vorgesehen und es wird die in allen drei Phasen verbrauchte Energie gemessen. Um die Phasenspannungen und -ströme auf das Potential der Meß- und Auswerteschaltung zu bringen, müssen diese in bekannter Weise transformatorisch gekoppelt werden. Damit erhält man auf einfache Weise einen Drei-Phasenzähler, bei dem sich zusätzlich die interessante Möglichkeit bietet, die einzelnen Phasenströme auf Abruf hin anzuzeigen, wenn es darum geht, in einer Installation die Gleichverteilung der Lasten auf die drei Phasen zu überprüfen oder anzupassen.

Wie bereits aus der obigen Beschreibung ersichtlich ist, sind durch die Tatsache, daß die zum Verbraucherstrom bzw. zur Verbraucherspannung proportionalen Spannungswerte in digitaler Form am Ausgang des AD-Wandlers nacheinander in einer Form anliegen, in der sie von einem Mikroprozessor einzeln weiterverarbeitbar sind, vielfältige Auswertungsmöglichkeiten durch den Mikroprozessor geschaffen worden.

Nachfolgend wird die Auswertung der Abtastwerte von Strom und Spannung am Beispiel eines Zwei-Tarifzählers für Wirkleistung dargestellt :

| Digitalisierte Abtastwerte vom A/D-Wandler | | | |
|---|---|---|---|
| Abtastwerte der Spannung, 8 Bit | | Abtastwerte des Stromes, 11 Bit | |
| | Mittelwertbildung für Offsetkorrektur | | Mittelwertbildung für Offsetkorrektur |
| Addition der Offsetkorrektur zu den Abtastwerten der Spannung | | Addition der Offsetkorrektur zu den Abtastwerten des Stromes | |
| Multiplikation der Spannungs- und Strom-Abtastwerte, U x I | | Bildung des absoluten Betrages der Stromabtastwerte | |
| Multiplikation der Energieinkremente mit dem Eichfaktor, k x $\Delta E$ | | Bildung des linearen Mittelwertes | |
| Integration der Energieinkremente und Ausgabe von positiven oder negativen Zählimpulsen je Wh (Wattstunde) | | | |
| Unterdrückung negativer Zählimpulse zur Sperrung des Zählers bei Rückspeisung von Energie ins Netz | | | |
| Unterdrückung der Zählimpulse, wenn minimaler linearer Mittelwert des Stromes (Ansprechstrom) unterschritten wird | | | |
| Tarifsteuerung: Zuordnung der Zählimpulse zum entsprechenden Zählregister | | | |
| Zählregister 1 für Hochtarif | | Zählregister 2 für Niedertarif | |

## Patentansprüche

1. Elektronischer Energieverbrauchszähler mit einer Einrichtung zur Erzeugung eines zur Verbraucherspannung proportionalen Spannungssignals ($V_u$), einem ersten Zwischenspeicher (2), dem das Spannungssignal ($V_u$) zugeführt wird, einer Einrichtung (4) zur Erzeugung eines zum Verbraucherstrom proportionalen Spannungssignals ($V_i$), einem zweiten Zwischenspeicher (7), dem das Spannungssignal

4

($V_i$) zugeführt wird, einem Analog-Digital-Wandler (A/D-Wandler) (11) und einem Schalter (9), der die am Ausgang der Zwischenspeicher (2, 7) anliegenden Abtastwerte ($V_u$, $V_i$) mit einer bestimmten Abtastfrequenz abwechselnd dem A/D-Wandler (11) zuführt, der sie dann nacheinander in digitaler Form einem Mikroprozessor (13) zur Weiterverarbeitung zuführt, wobei die Einrichtung zur Erzeugung eines zum Verbraucherstrom proportionalen Spannungssignals ($V_i$) zwischen Phaseneingang und -ausgang einen Nebenwiderstand oder Shunt (3), wobei der Phaseneingang mit dem ersten Eingang eines Operationsverstärkers (6) verbunden ist, und einen Meßwiderstand (5) aufweist, der zwischen dem Phasenausgang und dem zweiten Eingang des Operationsverstärkers (6) geschaltet ist, und das zum Verbraucherstrom proportionale Spannungssignal ($V_i$) am Ausgang des Operationsverstärkers (6) abgenommen wird, dadurch gekennzeichnet, daß der Nebenwiderstand (3) und der Meßwiderstand (5) thermisch eng miteinander gekoppelt sind, so daß sich der Meßwiderstand (5) bei Temperaturänderungen prozentual gleich verändert wie der Nebenwiderstand (3) und so ein temperaturkompensiertes Spannungssignal ($V_i$) am Ausgang des Operationsverstärkers geliefert wird.

2. Zähler nach Anspruch 1, dadurch gekennzeichnet, daß der Nebenwiderstand (3) und der Meßwiderstand (5) aus einem Material mit gleichem Temperaturkoeffizienten sind.

3. Zähler nach einem der Ansprüche 1 oder 2, dadurch gekennzeichnet, daß der Meßwiderstand (5) um den Nebenwiderstand (3) herumgewickelt sowie bifilar als isolierter Draht auf dem Nebenwiderstand (3) aufgewickelt ist.

4. Zähler nach Anspruch 3, dadurch gekennzeichnet, daß der Nebenwiderstand (3) durch einen umfassenden Schrumpfschlauch auf dem Meßwiderstand (5) fixiert ist.

5. Zähler nach einem der Ansprüche 1 bis 4, dadurch gekennzeichnet, daß der Nebenwiderstand (3) vom Verbindungssteg zwischen dem Phaseneingang und -ausgang im Klemmblock des Zählers gebildet wird.

6. Zähler nach einem der Ansprüche 1 bis 5, dadurch gekennzeichnet, daß zwischen dem Schalter (9) und dem A/D-Wandler (11) ein programmierbarer Verstärker (10) geschaltet ist, der mit dem Mikroprozessor (13) verbunden und hinsichtlich des Verstärkungsfaktors so veränderbar ist, daß der A/D-Wandler (11) auch bei veränderten Spannungswerten ($V_i$) voll ausgesteuert ist und daß die Feststellung des Spannungswerts ($V_i$) in zwei Schritten erfolgt, wobei im ersten Schritt der programmierbare Verstärker (10) auf einen Verstärkungsfaktor 1 und im zweiten Schritt auf ein Vielfaches dieses Verstärkungsfaktors so einstellbar ist, daß der gesamte Amplitudenbereich des A/D-Wandlers (11) ausnutzbar ist.

**Claims**

1. Electronic energy consumption meter with a device for generating a voltage signal ($V_u$) proportional to the user voltage, a first intermediate store (2) to which the voltage signal ($V_u$) is fed, a device (4) for generating a voltage signal ($V_i$) proportional to the user current, a second intermediate store (7) to which the voltage signal ($V_i$) is fed, an analogue digital converter (A/D converter) (11) and a circuit (9) which feeds the sample values ($V_u$, $V_i$) present at the output of the intermediate store (2, 7) with a given sampling frequency alternately to the A/D converter (11), which then sequentially feeds them in digitised form to a microprocessor (13) for further processing, wherein the device for generating a voltage signal ($V_i$) proportional to the current use is a shunt resistance or shunt (3) between phase entry and exit, wherein the phase entry is connected with the first input of an operational amplifier (6) and has a measuring resistance (5) which is connected between the phase output and the second input of the operational amplifier (6) and that voltage signals ($V_i$) proportional to the user current are taken off at the output of the operational amplifier (6), characterised in that the shunt resistance (3) and the measuring resistance (5) are coupled with one another thermally closely so that the measuring resistance (5) on temperature changes changes in percentage terms evenly as does the shunt resistance (3) and thus a temperature compensated voltage signal ($V_i$) is provided at the output of the operational amplifier.

2. Meter according to claim 1 characterised in that the shunt resistance (3) and the measuring resistance (5) are of a material with the same temperature co-efficients.

3. Meter according to one of claims 1 or 2, characterised in that the measuring resistance (5) is wound around the shunt resistance (3) as well as being wound in bifilar fashion as an insulated wire on the shunt resistance (3).

4. Meter according to claim 3 characterised in that the shunt resistance (3) is fixed by a surrounding shrink sleeve on to the measuring resistance (5).

5. Meter according to one of claims 1 to 4 characterised in that the shunt resistance (3) is formed by the connection bar between the phase entry and outlet in the clamping block of the meter.

6. Meter according to one of claims 1 to 5 characterised in that between the circuit (9) and the A/D converter (11) a programmable amplifier (10) is connected which is connected with the microprocessor (13) and is so adjustable with reference to the amplification factor that the A/D converter (11) even with changed voltage values ($V_i$) is fully loaded and that the determination of the voltage value ($V_i$) takes place in two steps wherein in the first step the programmable amplifier (10) is adjusted to an amplification factor 1 and the second step to a multiple of this amplification factor in such a fashion that the whole amplitude region of the A/D converter (11) is usable.

**Revendications**

1. Compteur électronique de consommation d'énergie comportant un dispositif destiné à la création d'un signal de tension ($V_u$) proportionnel à la tension consommée, une première mémoire intermédiaire (2) dans laquelle est introduit le signal de tension ($V_u$), un dispositif (4) destiné à la création d'un signal de tension ($V_i$) proportionnel à l'intensité consommée, une deuxième mémoire intermédiaire (7) dans laquelle est introduit le signal de tension ($V_i$), un convertisseur analogique/numérique (convertisseur A/D) (11) et un commutateur (9) qui introduit alternativement des valeurs d'échantillonnage ($V_u$, $V_i$) qui se présentent à la sortie des mémoires intermédiaires (2, 7), avec une fréquence d'échantillonnage déterminée, dans le convertisseur analogique/numérique (11), qui les introduit les unes après les autres sous forme numérique dans un microprocesseur (13) en vue de leur traitement ultérieur, le dispositif destiné à la création d'un signal de tension ($V_i$) proportionnel à l'intensité consommée présentant, entre l'entrée et la sortie de la phase, une résistance en parallèle ou shunt (3), l'entrée de phase étant connectée à la première entrée d'un amplificateur opérationnel (6), et comportant une résistance de mesure (5) qui est branchée entre la sortie de phase et la deuxième entrée de l'amplificateur opérationnel (6), et le signal ($V_i$) de tension proportionnel à l'intensité consommée étant prélevé à la sortie de l'amplificateur opérationnel (6), caractérisé en ce que la résistance parallèle (3) et la résistance de mesure (5) sont accouplées entre elles thermiquement de façon étroite, de manière que lors des variations de température, la résistance de mesure (5) varie en pourcentage comme la résistance en parallèle (3) et à ce qu'ainsi un signal de tension compensé en température ($V_i$) soit délivré à la sortie de l'amplificateur opérationnel.

2. Compteur selon la revendication 1, caractérisé en ce que la résistance en parallèle (3) et la résistance de mesure (5) sont réalisées en des matériaux présentant les mêmes coefficients de température.

3. Compteur selon l'une des revendications 1 ou 2, caractérisé en ce que la résistance de mesure (5) est enroulée autour de la résistance en parallèle (3) sous la forme d'un fil isolé enroulé de façon bifilaire autour de la résistance en parallèle (3).

4. Compteur selon la revendication 3, caractérisé par le fait que la résistance en parallèle (3) est fixée à la résistance de mesure (5) par une gaine flexible qui l'entoure.

5. Compteur selon l'une des revendications 1 à 4, caractérisé en ce que la résistance en parallèle (3) est formée par la barrette de liaison entre l'entrée de phase et la sortie de phase dans le bloc de bornes du compteur.

6. Compteur selon l'une des revendications 1 à 5, caractérisé en ce qu'entre le commutateur (9) et le convertisseur analogique/numérique (11) est branché un amplificateur programmable (10) qui est connecté au microprocesseur (13) et qui peut être modifié en ce qui concerne le facteur d'amplificateur de telle façon que le convertisseur analogique/numérique (11) soit pleinement utilisé même lorsqu'il y a des valeurs de tension ($V_i$) qui sont modifiées, et en ce que l'établissement de la valeur de tension ($V_i$) s'effectue en deux étapes, l'amplificateur programmable (10) étant dans une première étape réglable sur un facteur d'amplification de 1 et dans une deuxième étape sur un multiple de ce facteur d'amplification, de telle façon qu'il puisse être utilisé sur l'ensemble du domaine d'amplification du convertisseur analogique/numérique (11).

Fig. 1

Fig. 2

Abtastwerte der Spannung

Spannung ——→ t

←→ τ

Abtastwerte des Stromes

Strom ——→ t

Leistung ——→ t

T

Abtastperiode

Abtastwerte der momentanen
Leistung

Fig. 3